**Europäisches Patentamt**

(19) **European Patent Office**

**Office européen des brevets**

(11) Numéro de publication : **0 077 757**
**B1**

(12) **FASCICULE DE BREVET EUROPÉEN**

(45) Date de publication du fascicule du brevet :
24.04.85

(51) Int. Cl.⁴ : **G 01 R 29/08**

(21) Numéro de dépôt : **82810423.2**

(22) Date de dépôt : **11.10.82**

(54) **Procédé pour détecter les défauts d'un revêtement diélectrique à la surface d'un substrat électriquement conducteur.**

(30) Priorité : 16.10.81 CH 6619/81

(43) Date de publication de la demande :
27.04.83 Bulletin 83/17

(45) Mention de la délivrance du brevet :
24.04.85 Bulletin 85/17

(84) Etats contractants désignés :
FR GB IT

(56) Documents cités :
AU-B-   436 753
FR-A- 1 338 781
FR-A- 2 354 563
GB-A- 2 015 165
US-A- 3 210 655

(73) Titulaire : **BATTELLE MEMORIAL INSTITUTE**
**7 route de Drize**
**CH-1227 Carouge/Genève (CH)**

(72) Inventeur : **Vermot-Gaud, Jacques**
**23a, route de Certoux**
**CH-1258 Perly (CH)**
Inventeur : **Kornmann, Michel**
**31, chemin des Palettes**
**CH-1212 Grand-Lancy (CH)**

(74) Mandataire : **Dousse, Blasco et al**
**7, route de Drize**
**CH-1227 Carouge/Genève (CH)**

Jouve, 18, rue St-Denis, 75001 Paris, France

## Description

La présente invention se rapporte à un procédé pour détecter les défauts d'un revêtement diélectrique à la surface d'un substrat électriquement conducteur. Ce procédé est applicable notamment à la détection des défauts de revêtement des pipe-lines sous-marins.

On sait que ces pipe-lines sont munis d'une double protection contre la corrosion, l'une étant constituée par un revêtement d'une couche de matière plastique et l'autre étant constituée par une protection par polarisation cathodique de l'acier du pipe-line par rapport à l'eau de mer, cette polarisation cathodique étant par exemple, obtenue en disposant à intervalles donnés, des anodes de zinc autour du pipe-line, cette polarisation s'établissant entre les bracelets de zinc et les parties du tube d'acier non protégées par le revêtement à la suite d'une détérioration de ce revêtement.

S'il est assez facile de détecter et de réparer les défauts produits avant la pose du pipe-line, rien n'est prévu en ce qui concerne les dommages qu'il subit au cours de la pose. Dans ces conditions, les bracelets de zinc sont disposés à des intervalles déterminés en fonction d'une évaluation statistique des défauts.

On a déjà proposé de contrôler la protection cathodique après la pose du pipe-line soit en mesurant le potentiel du pipe par rapport au milieu environnant soit en mesurant les courants de protection circulant soit dans le tube soit dans le milieu environnant. La mesure des courants de protection n'est pas utilisable durant la pose en raison des perturbations créées par les courants parasites provenant des nombreux appareils électriques utilisés durant la pose d'un pipe-line, tels que les courants de soudage.

Il existe déjà en électro-chimie des procédés pour étudier des états de surface par la mesure de l'impédance d'une surface plongée dans un milieu conducteur en utilisant une électrode excitée par un générateur de courant alternatif de fréquence moyenne et une électrode de mesure de potentiel placée très près de la surface étudiée. L'impédance résulte du rapport entre le potentiel mesuré et le courant d'excitation débité. Un tel procédé de mesure n'est utilisable que pour un examen réalisé très près (à quelques dizaines de microns) de la surface, étant donné qu'à une distance de l'ordre du millimètre, la faible résistivité du milieu, notamment lorsque ce milieu est de l'eau de mer, a tendance à uniformiser le potentiel entre l'électrode d'excitation et le substrat de sorte qu'il n'est plus possible de mesurer des variations d'impédance.

Le but de la présente invention est de permettre d'effectuer une mesure d'impédance de surface à une distance suffisante du substrat pour pouvoir déplacer relativement le substrat et une électrode d'excitation de façon à mesurer en continu les grands et les petits défauts même lorsqu'ils sont à proximité les uns des autres.

A cet effet, la présente invention a pour objet un procédé pour détecter les défauts d'un revêtement diélectrique à la surface d'un substrat électriquement conducteur, selon lequel on dispose une électrode d'excitation à distance de ce substrat du côté où celui-ci est recouvert par ledit revêtement, on place cette électrode et ce substrat dans un milieu électriquement conducteur commun et on porte les potentiels respectifs de ce substrat et de cette électrode à ceux des bornes d'un générateur de courant alternatif, voir aussi, par exemple, le US-A-3 210 655.

Le procédé de la présente invention est caractérisé par le fait que l'on interpose, entre cette électrode d'excitation et ce substrat, une bobine captrice orientée dans un plan sensiblement perpendiculaire aux lignes du champ électrique, que l'on dispose une électrode de mesure de potentiel dans l'ouverture de cette bobine, et que l'on détermine l'impédance résultant des tensions et courants détectés par ladite électrode de mesure et ladite bobine captrice.

L'avantage de ce procédé est d'être particulièrement bien adapté au contrôle du revêtement des pipe-lines sous-marins durant leur pose étant donné que les courants haute fréquence qui peuvent être utilisés sont insensibles aux courants parasites environnants tels que les courants de soudage et que la détection · peut être effectuée à une distance suffisante de la surface du substrat pour permettre d'effectuer le contrôle en continu, au fur et à mesure de la pose du pipe-line quand le tube a pénétré dans l'eau de mer et quitte le « stinger » qui constitue un élément de guidage du tube s'étendant à l'arrière de la barge utilisée pour la pose du pipe-line. Par conséquent, ce procédé permet d'effectuer un contrôle à un endroit où le tube a quitté tout contact avec l'installation de pose du pipe-line, susceptible de détériorer le revêtement de protection. Il est donc possible à l'aide de ce procédé de mesurer la surface de tube non protégée par le revêtement de matière plastique et de répartir les anodes de zinc en fonction de la protection par polarisation cathodique nécessaire, ou de réparer le revêtement du tube lorsque la surface d'acier dénudée dépasserait une valeur limite.

Le dessin annexé illustre, schématiquement et à titre d'exemple une forme d'exécution d'un moyen pour la mise en œuvre du procédé.

La figure 1 est une vue en élévation d'une barge de pose d'un pipe-line montrant la zone de contrôle du tube.

La figure 2 illustre un schéma de principe du dispositif de détection.

La figure 3 illustre un schéma d'une application du procédé à la détection des défauts de revêtement d'un tuyau.

La figure 4 est un diagramme de l'impédance mesurée en relation avec la surface des défauts et en fonction de la distance entre le substrat et la bobine captrice.

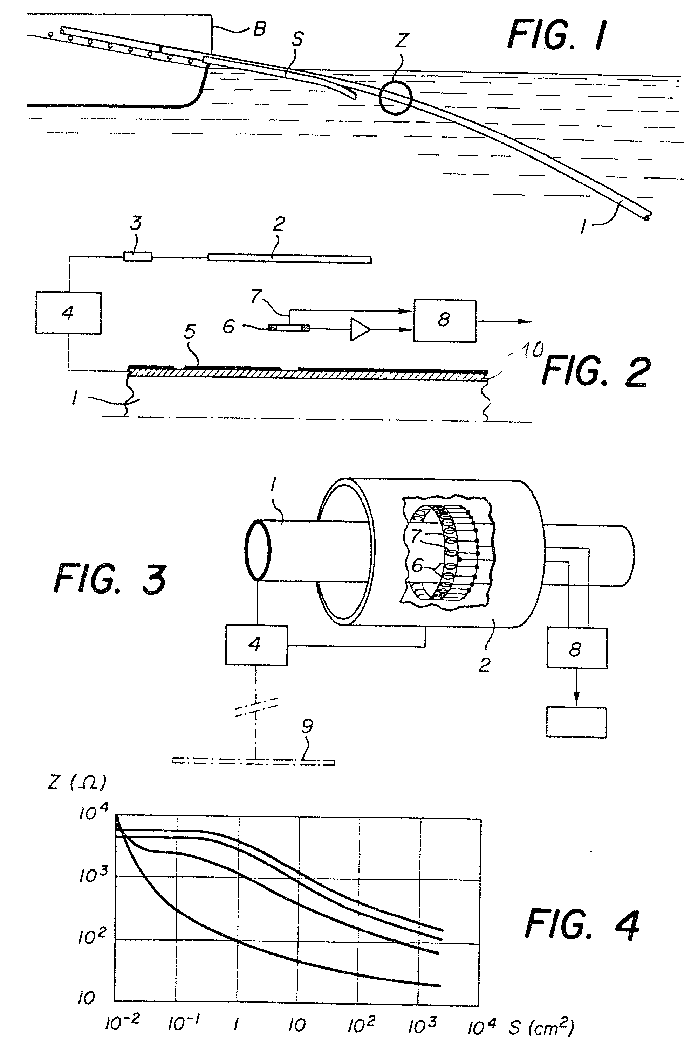

La figure 1 illustre simplement la zone Z dans laquelle il est souhaitable d'effectuer le contrôle du revêtement d'un substrat conducteur (10), constitué, dans cet exemple, par un tube 1. On voit que cette zone est immergée et se situe à la sortie du « stinger » S constituant la surface de guidage du tube située à l'arrière de la barge B.

Le principe sur lequel repose le procédé est expliqué en relation avec le dispositif de détection illustré par la fig. 2. Ce dispositif comporte une électrode d'excitation 2 située à une certaine distance du tube 1 et reliée par l'intermédiaire d'une résistance 3 à une borne d'un générateur de courant alternatif 4 dont l'autre borne est reliée au tube 1 entouré d'un revêtement diélectrique 5. Une bobine captrice torique 6 est disposée entre l'électrode d'excitation 2 et la paroi du tube 1 sensiblement parallèlement au substrat, de manière que les lignes du courant s'établissant entre l'électrode d'excitation 2 et le tube 1 traversent l'ouverture de la bobine captrice torique 6. Ainsi cette bobine captrice mesure la composante de courant normale au tube. En effet, si on admet par exemple une densité de courant constante i ayant une direction faisant un angle avec l'axe de révolution de la bobine torique, le courant traversant l'ouverture de cette bobine est :

$$I = I_0 \cos \alpha$$

Avec $I_0 = iS$, S étant la surface de cette ouverture.

Grâce à la directivité de la mesure du courant par la bobine captrice 6, il est possible d'avoir une information significative concernant le comportement électrique de la portion de surface du substrat située en face de cette bobine.

Une électrode 7 de mesure de potentiel est placée dans le plan de la bobine captrice 6 de façon à conférer une signification absolue à la mesure de courant. Ces signaux tension/courant sont recueillis par un organe récepteur 8 qui calcule la valeur de l'impédance existant entre le plan du tore et la surface du substrat. Cette directivité de la mesure est précisément la raison pour laquelle le procédé est capable de détecter de petits et de grands défauts situés côte-à-côte étant donné que la bobine détectrice 6 ne mesure que la composante de courant normale à la surface du substrat. Cette directivité est encore renforcée en choisissant l'électrode d'excitation 2 aussi grande que possible.

La fréquence du courant d'alimentation joue également un rôle dans la sensibilité de la mesure de courant. C'est ainsi qu'une fréquence de 10 000 Hz alimentant des bobines toriques de ferrite à perméabilité initiale élevée permettent d'atteindre des sensibilités de l'ordre de 10 à 100 mV/mA.

Une série de tests ont été réalisés en milieu simulé d'eau de mer sur un tronçon de tube recouvert d'une couche de polyéthylène de 3 mm d'épaisseur dont certaines parties ont été éliminées pour faire apparaître l'acier du tube. Ces portions de surface dénudées ont 2 et 5 mm de diamètre, 10 × 2 cm ou s'étendent sur une portion complète du tube. Pour simuler les conditions réelles, une anode de zinc est associée au tube.

Tableau

| Zone testée | Distance en cm D | Impédance (ohms) |
|---|---|---|
| Polyéthylène | 0,5 cm | 9 500 |
| | 3 cm | 8 000 |
| S = 0 | 5 cm | 6 200 |
| | 10 cm | 7 100 |
| Défaut ∅ 2 mm | 0,5 cm | 1 100 |
| | 3 cm | 4 700 |
| $S = 3 \cdot 10^{-2}$ cm² | 10 cm | 7 000 |
| Défaut ∅ 5 mm | 0,5 cm | 350 |
| | 3 cm | 2 400 |
| S = 0,2 cm² | 10 cm | 7 000 |
| Défaut 2 × 10 cm | 0,5 cm | 50 |
| | 3 cm | 375 |
| S = 20 cm² | 5 cm | 600 |
| | 10 cm | 750 |
| Surface nue | 0,5 cm | 20 |
| | 3 cm | 70 |
| S → ∞ | 5 cm | 100 |
| | 10 cm | 180 |

Deux diamètres de bobines captrices toriques 6 ont été testées, de 2,5 cm et 1 cm avec chacune 200 spires. Avec un courant de 10 kHz les sensibilités mesurées sont respectivement de 45 et 40 mV/mA. L'électrode d'excitation est alimentée par un courant limité à 150 mA.

Les mesures ont été effectuées tout le long du tube, au contact du revêtement soit à environ 5 mm du substrat, respectivement à 30, 50 et 100 mm. Le tableau ci-dessus montre les résultats obtenus avec la bobine captrice torique de 2,5 cm de diamètre.

Le diagramme de la fig. 4 donne une représentation graphique de ces résultats avec la distance entre la bobine captrice 6 et le substrat comme paramètre.

On constate qu'à une distance de 5 mm des défauts de l'ordre de $10^{-2}$ cm$^2$ sont détectables, à 3 cm, des défauts de $10^{-1}$ cm$^2$ le sont encore, à 5 cm il est possible de détecter des défauts à partir de 1 cm$^2$, tandis qu'à 10 cm cette limite se situe entre 5 et 10 cm$^2$.

La fig. 3 illustre une application du procédé selon l'invention à la détection des revêtements d'un pipe-line immergé dans l'eau de mer. Ce dispositif correspond exactement au schéma de principe de la fig. 2, une série de bobines captrices toriques 6 étant réparties annulairement autour du tube 1 et connectées à un organe récepteur 8 multicanaux, de même que les électrodes 7 de mesure de potentiel placées dans le plan de chaque bobine captrice. L'électrode d'excitation 2 est constituée par un anneau connecté à l'une des bornes du générateur de courant alternatif 4 dont l'autre borne est connectée au tube 1. Il est à noter que ce procédé de détection est également applicable à la détection des défauts des pipe-lines après leur pose en mer. Dans ce cas, au lieu de brancher la source de courant alternatif 4 au tuyau 1 comme ceci est facile à réaliser lors de la pose, on peut alors brancher la seconde borne de ce générateur 4 à une électrode 9 disposée très éloignée du tube 1 d'une distance 50 à 100 fois supérieure à celle entre l'électrode d'excitation 2 et le tube 1, ce qui permet d'atteindre pratiquement le même résultat qu'en mettant directement le tube au potentiel de la masse du générateur de courant alternatif.

On sait que dans bon nombre de cas, les pipe-lines immergés sont recouverts d'une couche de béton pour leur conférer un poids supérieur à la pression vers le haut exercée par le volume d'eau qu'ils déplacent. Des tests ont été effectués pour évaluer l'influence de la couche de béton sur la mesure et notamment l'influence de la résistivité du béton. La résistivité du béton peut varier dans une large mesure en fonction de sa composition, de sa préparation, de son âge et de l'eau qu'il contient. La résistivité en volume du béton 10 jours après sa préparation se situe entre 5 000 ohms.cm et 0,5 megohms.cm. Après 90 jours, la résistivité peut atteindre des valeurs de l'ordre de 500 megohms.cm et la résistivité du béton séché au four peut s'élever à $10^6$ megohms.cm.

Cependant dans le cas du pipe-line immergé, la résistivité dépend de l'absorption d'eau. Des essais ont montré que cette résistivité s'abaisse d'environ 1 megohm.cm à 10 000 ohms.cm quelques heures après que l'échantillon ait été immergé dans de l'eau de mer reconstituée. Ces valeurs sont à comparer avec la résistivité de l'eau de mer qui est de l'ordre de 30 ohms.cm. L'armature de renforcement en acier rend cependant la situation plus complexe.

Différents essais de mesures ont été réalisés avec des tuyaux d'acier revêtus de polyéthylène comme précédemment et d'une couche de béton de 5 cm avec ou sans renforcement par un grillage de fil d'acier de 1,6 mm et des mailles de 2,5 × 2,5 cm. Le béton a été dosé à 450 kg de ciment Portland pour 1 m$^3$ de sable (0-20). Les défauts simulés ont été réalisés par des perçages de 6 et 12 mm de diamètres.

Les mesures ont été réalisées à proximité immédiate de la couche de béton soit à 5 à 6 cm du tube d'acier. Les impédances mesurées avec des défauts dans la couche de béton aussi bien que dans le diélectrique adjacent au tube sont du même ordre de grandeur que ceux mesurés sans béton à la même distance du tube d'acier.

## Revendication

Procédé pour détecter les défauts d'un revêtement diélectrique (5) à la surface d'un substrat électriquement conducteur (10), selon lequel on dispose une électrode d'excitation (2) à distance de ce substrat (10) du côté où celui-ci est recouvert par ledit revêtement, on place cette électrode (2) et ce substrat (10) dans un milieu électriquement conducteur commun et on porte les potentiels respectifs de ce substrat et de cette électrode à ceux des bornes d'un générateur de courant alternatif (4) caractérisé par le fait que l'on interpose, entre cette électrode d'excitation (2) et ce substrat (10), une bobine captrice (6) orientée dans un plan sensiblement perpendiculaire aux lignes du champ électrique, que l'on dispose une électrode de mesure de potentiel (7) dans l'ouverture de cette bobine, et que l'on détermine l'impédance résultant des tensions et courants détectés par ladite électrode de mesure et ladite bobine captrice.

## Claim

A method for detecting faults in a dielectric coating (5) coated on the surface of an electrically conductive substrate (10) in which an excitation electrode (2) is positioned at a distance from this substrate (10) on the side of the latter which is covered by said coating, this electrode and this substrate

**0 077 757**

are placed in an electroconductive medium and these elements are raised to the voltages of, respectively, the terminals of an AC generator (14), characterized in that a pick-up coil (6) oriented in a plane substantially perpendicular to the electric lines of the field is interposed between this excitation electrode (2) and this substrate (10) and a voltage measuring electrode (7) is positioned in the opening of this coil, and the impedance resulting from the voltages and the current detected by said measuring electrode and said pick-up coil is ascertained.

**Patentanspruch**

Verfahren zum Anzeigen der Fehler einer dielektrischen Beschichtung (5) auf der Oberfläche eines elektrisch leitenden Substrats (10), gemäß welchem man eine Erregerelektrode (2) im Abstand von diesem Substrat (10) auf der Seite anordnet, wo dieses mit der Beschichtung bedeckt ist, man diese Elektrode (2) und dieses Substrat (10) in ein gemeinsames elektrisch leitendes Mittel plaziert, und man die entsprechenden Potentiale dieses Substrats und dieser Elektrode denjenigen der Anschlußklemmen eines Wechselstromgenerators (4) zuführt, dadurch gekennzeichnet, daß man zwischen diese Erregerelektrode (2) und dieses Substrat (10) eine Meßspule (6) einsetzt, die in einer im wesentlichen senkrecht zu den Linien des elektrischen Kraftfeldes liegenden Ebene ausgerichtet ist, daß man eine Potential-Meßelektrode (7) in die Öffnung dieser Spule setzt, und daß man die aus den durch die Meßelektrode und die Meßspule festgestellten Spannungen und Strömen resultierende Impedanz bestimmt.

FIG. 1

FIG. 2

FIG. 3

FIG. 4